# EUROPEAN PATENT APPLICATION

(11) **EP 0 743 658 A2**
(43) Date of publication of application: **20.11.1996**
(21) Application number: 96303476.4
(22) Date of filing: 16.05.1996
(51) Int. Cl.: H01B 12/10

(54) **Aluminium stabilized superconductors and methods of construction**

(30) Priority: 17.05.1995 US 443305
(71) Applicant: THE BABCOCK & WILCOX COMPANY, New Orleans, Louisiana 70160-0035 (US)
(72) Inventor: Huang, Xianrui, Forest, Virginia 24551 (US); Lehmann, Gregory Alan, Evington, Virginia 24550 (US); Lvovsky, Yury, Lynchburg, Virginia 24503 (US); Wood, Ronald Glenn, Forest, Virginia 24551 (US)
(74) Representative: Pilch, Adam John Michael

(57) **Abstract**

An aluminium stabilized superconductor (10) in which superconducting cable (12) is embedded within a high purity aluminum stabilizer (14). The stabilizer (14) is, in turn, partially surrounded by an aluminum alloy sheath (16). The aluminum alloy sheath (16) is constructed so that at least one exterior surface (18) of the stabilizer (14) is open for exposure to a coolant. Preferably, this open exterior surface (18) of the stabilizer (14) is knurled for greater cooling efficiency.

## Description

This invention relates to aluminium stabilized superconductors and methods of construction, and in particular to a technique of mechanically supporting a superconducting cable which is embedded within a stabilizing material.

Many methods exist that mechanically support a superconducting cable embedded within a softer stabilizing material. US Patent No. US-A-3 614 301 (Royet) and US Patent No. US-A-3 646 249 (Moisson-Franckhauser) are typical of such devices. Both disclose a superconducting cable disposed within a tubular stabilizer which, in turn, is encased within an outer sheath. Coolant passes through the centre of the tubular stabilizer thereby cooling the stabilizer as well as the embedded superconducting cables. In both cases, the outer sheath, which is constructed of a single unitary material, fully surrounds the stabilizer. The manner of fully enclosing the stabilizer within the unitary outer sheath is both cumbersome and difficult to construct if a tight bond between the two is desired. Also, the conductor will undergo a sharp pressure rise during quenching since it requires leak-tight manifolding.

US Patent No. US-A-3 432 783 (Britton et al.) discloses a layer of superconducting material attached to a substrate. The superconducting material is subsequently grooved so as to form multiple strips on the substrate. A layer of normal conductor material is then installed around both the superconducting material and the substrate such as by vapour deposition, electroplating or the like. This conductor material is, in turn, enclosed within a thin insulative coating of aluminum oxide. Consequently, in this version, the coolant passes along the outside of the aluminum oxide coating so that any cooling of the embedded superconducting material must first pass through multiple insulative layers before any cooling action reaches the superconducting material. Also, the boundary between each such layer increases the thermal resistance that must be overcome to achieve cooling of the superconducting material.

Other devices of interest include US Patent No. US-A-4 334 123 (Tada et al.) which discloses a stabilizer having an open knurled passageway therethrough. This stabilizer is surrounded top and bottom by a pair of reinforcement members and on its sides by a pair of superconducting wires. US Patent No. US-A-4 490 578 (Suzuki et al.) discloses a plurality of superconductor wires encased within solder or the like which bonds to a pure copper housing. This solder also surrounds a reinforcing member and is capped by a lid constructed of a pure aluminium portion and a pure copper portion. US Patent No. US-A-4 079 187 (Fillunger et al.) discloses a superconducting cable which incorporates both stabilizing wires and reinforcing wires. This superconducting cable is placed within a groove in one stabilizing member with another stabilizing member placed thereover so as to cover the groove. The covering stabilizing member contains a passageway therein for the passage of a coolant therethrough. These stabilizing members themselves are soldered or brazed together before being fully enclosed within a steel sheath.

According to one aspect of the invention there is provided a conductor comprising:
a superconducting cable;
a high purity aluminium stabilizer surrounding said superconducting cable; and
sheath means for supporting said stabilizer, said sheath means being constructed of aluminium alloy and partially surrounding the exterior of said stabilizer, said sheath means being constructed and arranged to leave a portion of the exterior of said stabilizer uncovered or open for exposure to a coolant.

According to another aspect of the invention there is provided a method of constructing a superconductor, the method comprising the steps of:
embedding a superconducting cable within a high purity aluminium stabilizer; and
partially surrounding said high purity aluminium stabilizer with a sheath constructed of aluminium alloy, said sheath supporting said stabilizer and being constructed and arranged to leave a portion of the exterior surface of said stabilizer uncovered or open for exposure to a coolant.

A preferred embodiment of this invention provides a technique of manufacturing an aluminium stabilized superconductor which is supported by an aluminium alloy sheath. The preferred aluminium alloy sheath is composed of multiple components which are individually attached or secured together so as to provide support to the stabilizer. The preferred sheath does not fully enclose the stabilizer but instead only partially surrounds the stabilizer, thereby permitting one side of the stabilizer to be directly exposed to the coolant for greater cooling of the embedded superconducting material. The coolant preferably flows outside the stabilizer rather than through a passageway within the stabilizer. The enclosed stabilizer is physically secured to the outer sheath, whether this outer sheath is of singular or multi-piece construction.

In the preferred embodiment, the conductor consists of a superconducting cable that is surrounded by a high purity aluminium stabilizer. The sheath assembly, in turn, partially surrounds this stabilizer for support but this sheath stops short of fully enclosing the stabilizer. Instead, at least one side of the stabilizer remains uncovered by the sheath assembly so that this side remains open for (preferably direct) exposure to the coolant. This sheath is generally constructed of aluminium alloy and it may be of unitary or multi-piece construction.

The invention will now be described by way of example with reference to the accompanying drawings, throughout which like parts are referred to by like references, and in which:
Figure 1 is a schematic sectional view of a superconductor enclosed within a stabilizer that is supported by a sheath, according to an embodiment of the invention;
Figure 2 is a schematic sectional view of an alternative design to that shown in Figure 1, wherein the supporting sheath is constructed of multiple components which are fitted together; and
Figures 3A to 3D are schematic sectional views of a further alternative design to those shown in Figures 1 and 2, wherein the various components of the sheath are illustrated as being welded or brazed together.

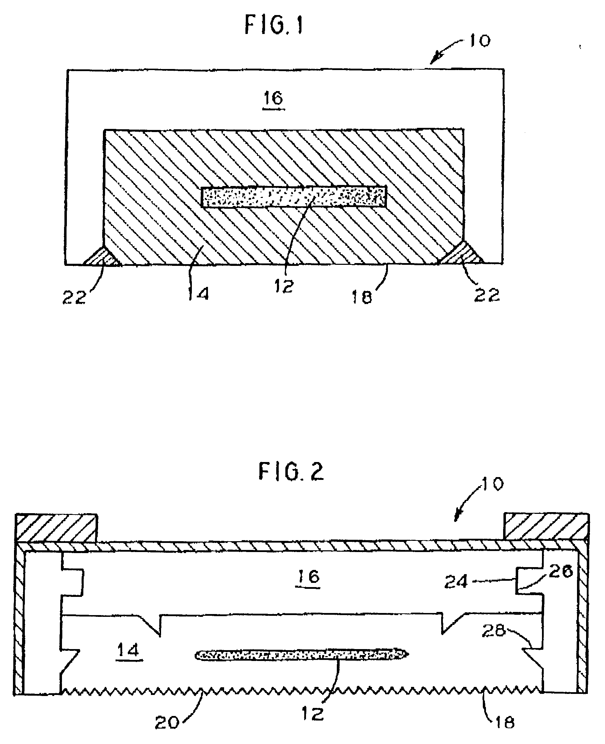

Referring initially to Figure 1, there is shown a superconductor 10 which, in this embodiment, comprises a superconducting cable 12, a stabilizer 14, and a sheath 16. The superconducting cable 12 may be a continuous ribbon of superconducting material or the cable 12 may consist of a plurality of individual wires that are braided, twisted, or otherwise held together.

The stabilizer 14 is generally constructed of high purity aluminum that is soft and has extremely low electric resistivity at cryogenic temperatures. Such low resistivity is necessary for conductor stability and protection. Generally, the superconducting cable 12 and the stabilizer 14 will be co-extruded so as to achieve a good metallurgical bond between the two. Such a manner of construction will also reduce the thermal and electrical resistance values arising at their interface. The stabilizer 14 serves the purpose of stabilizing or steadying the superconducting cable 12 during its cooling and use.

As indicated in Figure 1, one side or surface 18 of the stabilizer 14 is not enclosed by the sheath 16. Instead, this surface 18 is open for direct exposure to the coolant (not shown) used to cool the superconductor 10. It may also be desirable to knurl or roughen the surface 18 (as shown at 20 in Figure 2) so as to enhance the cooling of both the stabilizer 14 and the superconducting cable 12. In any event, the direct contact with the coolant by the stabilizer 14 as provided by the open nature of the sheath 16 will enable the superconductor 10 to be readily cooled so as to achieve the desired superconducting characteristics of the cable 12.

The sheath 16 is also generally constructed of aluminium and it provides mechanical support to the relatively soft stabilizer 14. Such support is needed to counter or resist the Lorentz forces that arise within the superconductor 10. The sheath 16 can be co-extruded with the stabilizer 14, or the sheath 16 can be welded (such as by TIG, laser or electron beam welding) to the stabilizer 14 via welds 22. Other methods can also be used to secure or lock the sheath 16 with respect to the stabilizer 14. In any event, a good mechanical bond between the sheath 16 and the stabilizer 14 is desired.

Referring now to Figure 2, there is shown an alternative embodiment of the superconductor 10. In this alternative embodiment, the sheath 16 is constructed of three separate pieces that are locked together around the stabilizer 14. These separate pieces will normally be continuously extruded and typically will incorporate keys 24 and keyways 26 that interlock for proper alignment and fit. In this fashion, the superconductor 10 can be continuously assembled as these co-extruded pieces are press-fitted together around the stabilizer 14. Additionally, teeth 28 can also be formed on these separate pieces that are designed to cut into the soft high purity aluminium of the stabilizer 14, thereby further mechanically locking the stabilizer 14 to the sheath 16.

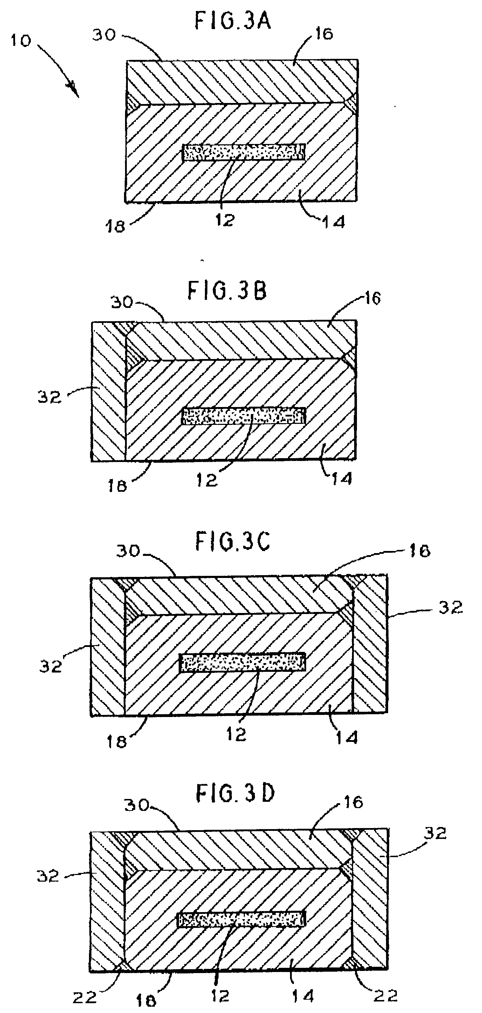

A further embodiment of the above multi-piece sheath 16 is shown in Figures 3A to 3D (in contrast to the unitary sheath of Figure 1). In this embodiment, the manner of constructing the sheath 16 partially around the stabilizer 14 is as follows. First, an upper sheath member 30 is welded to the top of the stabilizer 14 (Figure 3A). Following this, one side member 32 and then the other opposite side member 32 are secured to the upper sheath member 30 (Figures 3B and 3C). Finally, the open side 18 of the stabilizer 14 is secured to the respective side members 32 of the sheath 16 (Figure 3D). In this manner, each of the four corners of the stabilizer 14 are secured to the adjacent sheath members 30 and 32 while still permitting the stabilizer 14 to have a side or surface 18 that is not covered or enclosed for direct contact with the coolant. The normal manner of securing such sheath members 30 and 32 to the stabilizer 14 involves TIG, laser or electron beam welding or brazing, but other means of securing these members to the stabilizer 14 would also be acceptable.

The above designs of the superconductor 10 are ideal since superconductors are usually accompanied by large magnetic forces, large displacements and potentially large thermal disturbances. Consequently, such a superconductor 10 requires both a stable conductor 12 and reliable mechanical support for the conductor 12. Currently-existing aluminium stabilized superconductors are either completely wrapped by a high strength sheath or they lack such a sheath altogether. The former (those with a totally enclosing sheath) have poor stability due to poor thermal conductivity of sheath material and the thermal resistance at the contact or interface between the stabilizer and the sheath material. The latter (those lacking a sheath altogether) do not have or incorporate sufficient mechanical support for the stabilizer which, as stated earlier, is constructed of soft, high purity aluminium. The designs for the superconductor 10 as disclosed herein satisfy both the need for stability and the need for mechanical support of the soft stabilizer. A further added benefit of such designs for the superconductor 10 are their ease of assembly which reduces their cost of manufacture. Also, since these designs incorporate aluminum, they are lighter in weight than other designs which incorporate copper. This is, therefore, an ideal choice for large superconducting coils.

## Claims

1. A conductor comprising:
a superconducting cable (12);
a high purity aluminium stabilizer (14) surrounding said superconducting cable (12); and
sheath means (16) for supporting said stabilizer (14), said sheath means (16) being constructed of aluminium alloy and partially surrounding the exterior of said stabilizer (14), said sheath means (16) being constructed and arranged to leave a portion (18) of the exterior of said stabilizer (14) uncovered or open for exposure to a coolant.

2. A conductor according to claim 1, wherein said sheath means (16) is welded (22) or brazed to said stabilizer (14).

3. A conductor according to claim 1 or claim 2, wherein said uncovered or open portion (18) of said stabilizer (14) is knurled (20) for greater cooling efficiency.

4. A conductor according to claim 1, claim 2 or claim 3, wherein said sheath means (16) is of unitary construction.

5. A conductor according to claim 1, claim 2 or claim 3, wherein said sheath means (16) is of multi-piece construction (30,32).

6. A conductor according to claim 5, wherein the multi-piece sheath means (16) comprises keys (24) and keyways (26) therein for locking and aligning said multi-piece sheath means (16) together.

7. A conductor according to claim 5 or claim 6, wherein the multi-piece sheath means (16) comprises teeth (28) for cutting into and mechanically locking said sheath means (16) to said stabilizer (14).

8. A conductor according to claim 5, claim 6 or claim 7, wherein said stabilizer (14) is generally constructed as a polygon and wherein said sheath means (16) comprises multiple sheath members (30,32) secured to and covering multiple exterior surfaces of said stabilizer (14) while leaving at least one exterior surface (18) of said stabilizer (14) uncovered or open for exposure to a coolant.

9. A conductor according to claim 8, wherein said multiple sheath members (30,32) abut and are secured to each other.

10. A method of constructing a superconductor, the method comprising the steps of:
embedding a superconducting cable (12) within a high purity aluminum stabilizer (14); and
partially surrounding said high purity aluminium stabilizer (14) with a sheath (16) constructed of aluminum alloy, said sheath (16) supporting said stabilizer (14) and being constructed and arranged to leave a portion (18) of the exterior surface of said stabilizer (14) uncovered or open for exposure to a coolant.

11. A method according to claim 10, comprising the step of welding (22) or brazing said sheath (16) to said stabilizer (14).

12. A method according to claim 10 or claim 11, comprising the step of knurling (20) said uncovered or open portion (18) of the exterior surface of said stabilizer (14) for greater cooling efficiency.

13. A method according to claim 10, claim 11 or claim 12, comprising the step of constructing said sheath (16) of a unitary aluminium alloy material.

14. A method according to claim 10, claim 11 or claim 12, comprising the step of constructing said sheath (16) of a multi-piece aluminium alloy material.

15. A method according to claim 14, comprising the step of constructing and arranging the multi-piece sheath (16) with keys (24) and keyways (26) therein for locking and aligning said multi-piece sheath (16) together.

16. A method according to claim 14 or claim 15, comprising the step of constructing and arranging the multi-piece sheath (16) with teeth (28) for cutting into and mechanically locking said sheath (16) to said stabilizer (14).

17. A method according to claim 14, claim 15 or claim 16, comprising the steps of generally constructing said stabilizer (14) as a polygon, and securing and covering multiple exterior surfaces of said stabilizer (14) with multiple sheath members (30,32) while leaving at least one exterior surface (18) of said stabilizer (14) uncovered or open for exposure to a coolant.

18. A method according to claim 17, comprising the step of securing and abutting said sheath members (30,32) together.
